# EUROPEAN PATENT SPECIFICATION

(11) **EP 3 476 031 B1**
(45) Date of publication and mention of the grant of the patent: **17.01.2024**
(21) Application number: 16732634.7
(22) Date of filing: 28.06.2016
(51) Int. Cl.: H02M 1/36, H02M 7/483, H02M 1/32, H02M 1/08, H03K 17/0812

(54) **PROTECTION OF SEMICONDUCTORS IN POWER CONVERTERS**
SCHUTZ VON HALBLEITERN IN LEISTUNGSWANDLERN
PROTECTION DE SEMI-CONDUCTEURS DANS DES CONVERTISSEURS DE PUISSANCE

(43) Date of publication of application: 01.05.2019
(73) Proprietor: Hitachi Energy Ltd, 8050 Zürich (CH)
(72) Inventor: ØDEGÅRD, Bjørn, 5300 Turgi (CH); WEISS, David, 22850 Norderstedt (DE); BAUMANN, Remo, 5600 Lenzburg (CH)
(74) Representative: AWA Sweden AB
(86) International application number: PCT/EP2016/064945
(87) International publication number: WO 2018/001455

(56) References cited:
- EP-A1- 2 988 404
- WO-A1-2015/113033
- US-A1- 2008 232 145
- US-A1- 2013 181 532
- US-A1- 2014 139 167
- STEIMER PETER K ET AL: "Converter-fed synchronous machine for pumped hydro storage plants", 2014 IEEE ENERGY CONVERSION CONGRESS AND EXPOSITION (ECCE), IEEE, 14 September 2014 (2014-09-14), pages 4561-4567, XP032680866, DOI: 10.1109/ECCE.2014.6954025 [retrieved on 2014-11-11]
- LUDOIS D C ET AL: "Modular multilevel converter as a low inductance machine drive", POWER AND ENERGY CONFERENCE AT ILLINOIS (PECI), 2012 IEEE, IEEE, 24 February 2012 (2012-02-24), pages 1-4, XP032168483, DOI: 10.1109/PECI.2012.6184609 ISBN: 978-1-4577-1681-2
- SENTURK OSMAN S ET AL: "High voltage cell power supply for modular multilevel converters", 2014 IEEE ENERGY CONVERSION CONGRESS AND EXPOSITION (ECCE), IEEE, 14 September 2014 (2014-09-14), pages 4416-4420, XP032680544, DOI: 10.1109/ECCE.2014.6953725 [retrieved on 2014-11-11]
- Schneider Electric: "Catalog June 2015 Variable speed drives Altivar Process ATV900", , 30 June 2015 (2015-06-30), XP055487697, Retrieved from the Internet: URL:http://www.altivar.be/pdf/cat_atv9xx_a ng.pdf [retrieved on 2018-06-25]

## Description

### TECHNICAL FIELD

The present disclosure relates to a device and method for protection of semiconductors in power converters from voltage surges.

### BACKGROUND

A Modular Multilevel power Converter (MMC), also known as Chain-Link Converter (CLC), comprises a plurality of converter cells, or converter sub-modules, serially connected in converter branches, or phase legs, that in turn may be arranged in a star, delta, direct or indirect converter topology. Each converter cell comprises, in the form of a half-bridge or full-bridge circuit, a capacitor for storing energy and power semiconductor switches such as insulated gate bipolar transistor (IGBT) devices, gate-turn-off thyristor (GTO) devices, integrated gate commutated thyristor (IGCT) devices, or Metal-Oxide-Semiconductor Field-Effect Transistor (MOSFET) devices for connecting the capacitor to the converter branch with one or two polarities. MMCs may be used in electric power transmission systems such as Static Synchronous Compensator (STATCOM), Frequency Converters in direct or indirect topology and High-Voltage Direct Current (HVDC) transmission. Relevant prior art for the present invention is:
- STEIMER PETER K ET AL: "Converter-fed synchronous machine for pumped hydro storage plants", 2014 IEEE ENERGY CONVERSION CONGRESS AND EXPOSITION (ECCE), IEEE, 14 September 2014 (2014-09-14), pages 4561-4567
- EP 2 988 404 A1

### SUMMARY

The present disclosure relates to a problem of the limited dv/dt robustness of un-powered gates of semiconductor switches in converters, especially gate commutated thyristors such as Integrated Gate Commutated Thyristor (IGCT), Reverse Conducting IGCT (RC-IGCT) and Bi-mode Gate Commutated Thyristor (BGCT), during charging from a DC-link. If the energy to power the gate unit of the thyristor is taken from the DC-link of the converter, the gate unit is un-powered during the first part of DC-link charging. If the converter is charged from the AC side with an alternating current (AC), after zero crossing from >o to <o and *vice versa* the current may commutate from one free wheeling diode to another. That implies that the dv/dt limit of the thyristor with un-powered gate unit might be exceeded during commutation. In addition to that, a bouncing circuit breaker that opens during charging could cause a excessive dv/dt. It is in accordance with the present invention proposed to add a protective capacitor arrangement at the input terminals of the converter to reduce the high dv/dt. The positioning of the protective capacitor arrangement may vary depending on requirements and topology.

The gate commutated thyristors have a relatively low dv/dt withstand capability if the gate unit is not powered. The difference of dv/dt capability between un-powered and powered gate unit may be in the range of an order of magnitude. If the power for the gate-unit is taken from the DC-link, the gate-unit is un-powered until a certain voltage is reached. During this time, too high dv/dt may occur caused by e.g. commutation of the current and/or bouncing of the circuit breaker which may destroy the semiconductors in the converter. To avoid this, a protection of the thyristors is proposed by means of using capacitors as dv/dt filter and/or replacing the circuit breakers with semiconductor switches.

According to an aspect of the present invention, there is provided a converter arrangement according to claim 1.

According to another aspect of the present invention, there is provided a method for protecting semiconductors in cell switches of a power converter according to claim 5.

The method comprises powering, by means of a power supply, gate units of the cell switches of at least one converter cell during start-up of the converter. A capacitor arrangement comprising at least one capacitor is connected between the semiconductors of the cell switches and the power supply. The capacitor arrangement protects the semiconductors from voltage surges during the start-up of the converter.

It is to be noted that any feature of any of the aspects may be applied to any other aspect, wherever appropriate. Likewise, any advantage of any of the aspects may apply to any of the other aspects. Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated. The use of "first", "second" etc. for different features/components of the present disclosure are only intended to distinguish the features/components from other similar features/components and not to impart any order or hierarchy to the features/components.

### BRIEF DESCRIPTION OF THE DRAWINGS

Embodiments will be described, by way of example, with reference to the accompanying drawings, in which:
Fig 1 is a schematic illustration of an embodiment of an MMC, in accordance with the present invention.
Fig 2a is a schematic circuit diagram of an embodiment of a bipolar converter cell, in accordance with the present invention.
Fig 2b is a schematic circuit diagram of an embodiment of a unipolar converter cell, in accordance with the present invention.
Fig 3 is a schematic circuit diagram of an example of a converter with protective capacitors connected to the main terminals of the converter, useful for the understanding of the present invention.
Fig 4 is a schematic circuit diagram of an embodiment of a converter connected to an auxiliary power supply with protective capacitors connected either the high-voltage side or the low-voltage side of the transformer of the auxiliary power supply, in accordance with the present invention.

### DETAILED DESCRIPTION

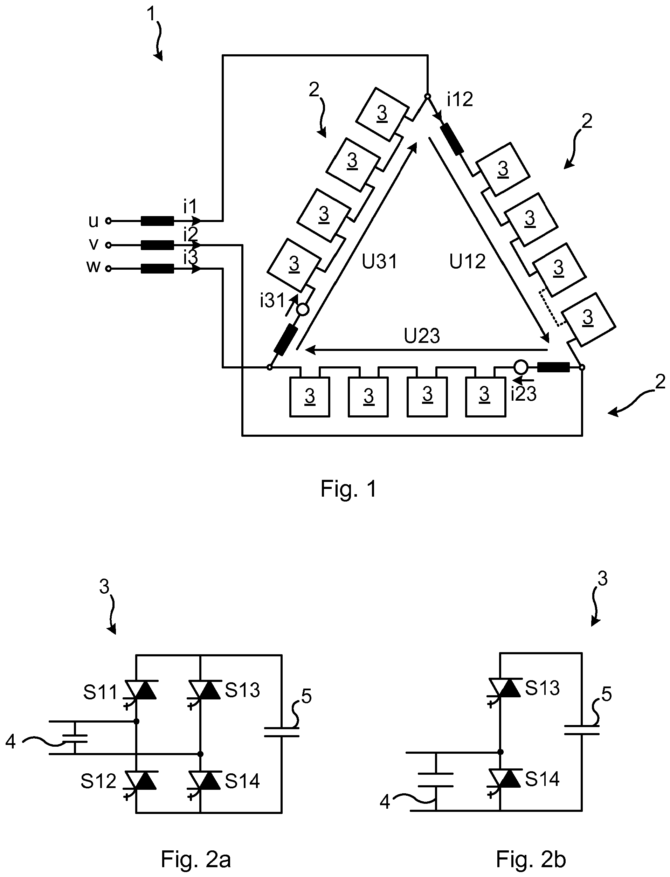

Embodiments will now be described more fully hereinafter with reference to the accompanying drawings, in which certain embodiments are shown. However, other embodiments in many different forms are possible within the scope of the present disclosure. Rather, the following embodiments are provided by way of example so that this disclosure will be thorough and complete, and will fully convey the scope of the disclosure to those skilled in the art. Like numbers refer to like elements throughout the description. Figure 1 is a schematic circuit diagram of an embodiment of an MMC 1, e.g. a high-voltage MMC. The MMC 1 may be used in electric power transmission systems such as STATCOM, Frequency Converters in direct or indirect topology or HVDC transmission. One or more (high-voltage) phases, u, v and w having respective currents i1, i2 and i3 are input to the converter 1 via input lines, e.g. via bushings through a wall of the room or building in which the converter 1 is located. In this example the MMC is in delta configuration with three phase legs 2, but any other configuration, such as star (wye, Y) or double-star configuration, and number of phase legs, e.g. three-phase to two-phase MMC, is also possible with embodiments of the present invention. Each phase leg 2 comprises a plurality of cascaded (series connected) cells (also called sub-modules) 3. The currents in the converter 1 are referred to as "i", while the voltages are referred to as "U" in the figure, in combination with arrows indicating directions.

The cells 3 may be of any suitable type, e.g. unipolar (also called half-bridge) or bipolar (also called full-bridge or H-bridge), comprising a power storing device, e.g. a capacitor, and a plurality of semiconductor switches.

Figure 2a illustrates an example of a bipolar cell 3. The cell comprises a power storing device 5, here in the form of a DC-link capacitor. The cell also comprises four semiconductor switches S, forming the full-bridge (H-bridge) topology in the cell. The semiconductor switches of the bipolar cell are named in the figures and text of the present disclosure as S11 switch, S12 switch, S13 switch and S14 switch. When the switches S11 and S14 are closed and S12 and S13 are open, a positive voltage will be applied. By opening S11 and S14 switches and closing S12 and S13 switches, this voltage is reversed. Each of the S switches may comprise e.g. an IGCT, an RC-IGCT or a BGCT, possibly in combination with an antiparallel one-direction conducting/blocking component such as a diode. In the example of figure 2a, each S switch comprises an IGCT and antiparallel diode. If the power supply of the IGCT gate of each S switch will be taken from the DC-link capacitor 5, the IGCT gate unit is un-powered during start-up until the DC-link voltage reaches a certain voltage level. If instead the converter 1, and thus the S switches, is charged with an AC current, after zero crossing from >o to <o, the current will commutate from S11 to S13 and from S12 to S14, respectively, and *vice versa.* That implies that the dv/dt limit of the IGCT with un-powered gate unit might be exceeded during charging.

Figure 2b illustrates an example of a unipolar cell 3. The cell comprises a power storing device 5, here in the form of a DC-link capacitor. The cell also comprises two semiconductor switches S, forming the half-bridge topology in the cell. The semiconductor switches of the unipolar cell are named in the figures and text of the present disclosure as S1 switch and S2 switch. As with the bipolar cell of figure 2a, each of the S switches may comprise e.g. an IGCT, an RC-IGCT or a BGCT, possibly in combination with an antiparallel one-direction conducting/blocking component such as a diode. In the example of figure 2b, each S switch comprises an IGCT and antiparallel diode. When a unipolar cell is used and charging is done with an AC current, only in the positive half wave of the current the diode of S1 is conducting current. That implies that if the current commutates from the diode of S1 to the diode of S2, the dv/dt limit of the un-powered IGCT might be exceeded.

Figures 2a and 2b also illustrate examples where protective capacitors 4 are connected to the AC terminals of each of the cells 3, at least one protective capacitor 4 for each cell 3 of the converter 1. A known problem of thyristors, e.g. IGCTs, is their limited dv/dt capability if the gate cathode is not shorted or the gate unit is not powered. In a two level and three-level inverter 1 the DC-link voltages may be limited by the blocking capability of the semiconductors of the S switches. Hence, the insulation requirements for the power supply of the semiconductors may be below 5-7 kV. State of the art is a galvanic separation of the semiconductor gate drive from the power supply of the gate drive. However, in a multilevel converter such as an MMC 1, the cells 3 are floating in a wide voltage range especially in high power medium voltage and HVDC applications. To keep down the insulation requirements of the gate drive power supply and facilitate scalability, the power for the gate drive may be taken from the DC-link. This, however, implies that until the start-up voltage of the cell power supply is reached, the gate units of the S semiconductor switches are un-powered.

Thus, if the power for supplying the gate-units is taken from the DC-link, a certain voltage is required to start switching the semiconductor devices of the S switches. During this phase, it has to be ensured that the dv/dt is limited to avoid a parasitic turn-on of the semiconductors.

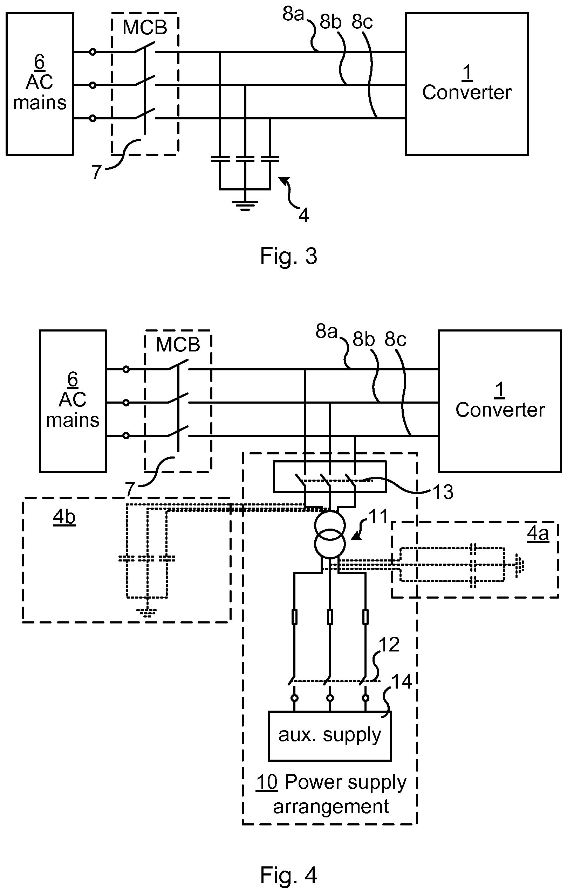

Different possible solutions to charge the gate units of the S switches of the converter 1 are shown in figures 3 and 4. The solution of figure 3 is referred to as resistive pre-charging from mains 6 and the solution shown in figure 4 is referred to as charging from auxiliary supply 14.

Referring to figure 3, the converter 1 is connected to an AC mains 6 power supply via main circuit breakers 7 (one for each phase) and main terminals 8 of the converter, e.g. one per phase (in this case a three-phase system with terminals 8a, 8b and 8c). In accordance with the present invention, protective capacitor(s) 4, e.g. at least one capacitor per terminal/phase, are connected to the main terminals 8 of the converter, here between the terminals and ground. These capacitors 4 protect the semiconductors of the S switches in the converter 1 during start-up charging from the AC mains 6 e.g. in case of bouncing circuit breakers 7 or other voltage/power surges.

Referring now to figure 4, the gate units of the S switches are start-up charged by means of an auxiliary power supply arrangement 10. The power supply arrangement 10 comprises an auxiliary power supply 14 connected to the terminals 8 of the converter 1 via charging breakers 12 (one for each phase), a transformer 11 (for increasing the voltage) and optional switches 13 connecting the power supply arrangement to the converter terminals 8. In this setup, the protective capacitor arrangement 4 (alternatives shown with dotted lines) may be positioned in different places as desired. The figure illustrates two different alternative positions. In a first embodiment, the capacitor arrangement 4a is connected to the low-voltage side of the transformer 11, e.g. between the low-voltage side of the transformer and ground. In a second embodiment, the capacitor arrangement 4b is connected to the high-voltage side of the transformer 11, e.g. between the high-voltage side of the transformer and ground. In both embodiments, the protective capacitor arrangement 4 is connected in the power supply arrangement 10 between the charging breakers 12 and the converter terminals 8, which would also be the case in embodiments where no transformer 11 is used. As discussed above, these capacitors 4 protect the semiconductors of the S switches in the converter 1 during start-up charging from the auxiliary power supply 14 e.g. in case of bouncing charging breakers 12 or other voltage/power surges.

The dv/dt (i.e. the speed with which the voltage changes/fluctuates over time) caused by contact bouncing of the circuit breakers 7 or charging breakers 12 may be limited by using the capacitor arrangement 4 when charging the gate units of the S switches from an AC power source such as the mains 6 and/or auxiliary power supply 14. Either the capacitor arrangement 4 may be connected on the high-voltage (primary) or on the low-voltage (secondary) side of the transformer 11, if charging from the auxiliary supply 14 is used. When connected on the low-voltage side, the capacitor arrangement 4a may in some embodiments be regarded as a dv/dt filter and may be used in combination with a capacitor arrangement 4b connected on the high-voltage side. In case of resistive pre-charging from the mains 6, the capacitor arrangement 4 may be placed on the AC terminals of the cell 3 (see figures 2a and 2b) and/or on the main terminals 8 of the converter (see figure 3).

dv/dt stress for the semiconductors of the S switches, e.g. IGCT:s in the converter 1, may be caused by the opening of the breaker, e.g. MCB 7 or charging breaker 12, under fault conditions during charging. When this happen at a voltage lower than the voltage required to charge the gate-units there is a high risk that the contact bouncing of the breaker 7 or 12 leads to a high dv/dt. This dv/dt could destroy the semiconductors in the S switches. The dv/dt caused by contact bouncing of the breaker 7 or 12 may be limited by using a capacitor arrangement 4 in accordance with the present invention. In addition, it may be possible to place a dv/dt filter 4a on the low voltage side of the auxiliary charging transformer 11.

Further, an additional solution to avoid high dv/dt is to replace the mechanical main circuit breakers 7 and/or the charging breakers 12 with semiconductor switches for charging from mains 6 or from auxiliary supply 14. The semiconductor switch 7 or 12 may have to switch at zero crossing of the current. When semiconductor switches are used for the breakers 7 and/or 12, no high dv/dt should be caused by an opening of the breaker.

In some other embodiments of the present invention, the power supply is an auxiliary power supply 14 provided by an auxiliary power supply arrangement 10 comprised in the converter arrangement and connected via charging breakers 12 to the converter terminals 8 between the converter 1 and the circuit breakers 7. Then, the capacitor arrangement 4 may be comprised in the power supply arrangement 10 and connected between the charging breakers 12 and the converter terminals 8. The auxiliary power supply arrangement 10 may also comprise a transformer 11 for increasing the voltage from the auxiliary power supply 14 to the converter 1. In some embodiments, the capacitor arrangement 4a is connected on the low-voltage side of the transformer 11. Additionally or alternatively, in some embodiments, the capacitor arrangement 4b is connected on the high-voltage side of the transformer 11. Additionally or alternatively, in some embodiments, the auxiliary power supply arrangement 10 further comprises a dv/dt filter 4a connected on the low-voltage side of the transformer 11.

To further reduce the risk of surges which may damage the semiconductors of the cell switches S, each of the circuit breakers 7 and/or each of the charging breakers 12 (if any) may in some embodiments comprise or consist of a semiconductor switch (in addition to or instead of a mechanical (galvanic) switch).

In some embodiments of the present invention, the cell switches S each comprises a gate commutated thyristor, e.g. an IGCT, an RC-IGCT, or a BGCT. Alternatively, any other type of semiconductor switch may be used in each of the cell switches S, such as an IGBT or MOSFET.

In some embodiments of the present invention, the converter is configured for a high-voltage application, e.g. a HVDC or STATCOM application, or for a high power/current medium voltage application.

The present disclosure has mainly been described above with reference to a few embodiments. However, as is readily appreciated by a person skilled in the art, other embodiments than the ones disclosed above are equally possible within the scope of the present disclosure, as defined by the appended claims.

## Claims

1. A converter arrangement comprising:
a power converter (1);
circuit breakers (7) configured to be connected to an AC mains (6);
converter terminals (8) for connecting the power converter to the AC mains (6) via the circuit breakers (7); and
an auxiliary power supply arrangement (10) comprising:
switches (13) arranged to connect the power supply arrangement (10) to the converter terminals (8);
an auxiliary power supply (14) and charging breakers (12), wherein the auxiliary power supply (14) is connected via the charging breakers (12) to the converter terminals (8) between the power converter (1) and the circuit breakers (7), wherein the auxiliary power supply (14) is configured for charging gate units of cell switches (S) of at least one converter cell (3) of the power converter during start-up of the power converter;
a transformer (11) for increasing the voltage from the auxiliary power supply (14) to the power converter (1), wherein the transformer is connected between the charging breakers (12) and the switches (13) of the auxiliary power supply arrangement (10); and
a capacitor arrangement (4a, 4b) comprising at least one capacitor, connected between the charging breakers (12) and the converter terminals (8) on the low-voltage side of the transformer (11) and/or on the high-voltage side of the transformer (11);
wherein the capacitor arrangement (4) is configured to protect semiconductors of the cell switches (S) from voltage surges (dv/dt) during the start-up of the power converter (1).

2. The converter arrangement of claim 1, wherein each of the charging breakers (12) comprises a semiconductor switch.

3. The converter arrangement of any preceding claim, wherein the cell switches (S) each comprises a gate commutated thyristor, e.g. an Integrated Gate Commutated Thyristor, IGCT; a Reverse Conducting IGCT, RC-IGCT; or a Bi-mode Gate Commutated Thyristor, BGCT.

4. The converter arrangement of any preceding claim, wherein the power converter (1) is configured for a high-voltage application, e.g. a High-Voltage Direct Current, HVDC, application.

5. A method for protecting semiconductors in cell switches (S) of a power converter (1) of a converter arrangement as defined in any one of the preceding claims, the method comprising:
powering, by means of the auxiliary power supply (14), the gate units of the cell switches (S) of said at least one converter cell (3) during start-up of the power converter (1);
wherein the capacitor arrangement (4) protects the semiconductors from voltage surges (dv/dt) during the start-up of the converter (1).

6. The method of claim 5, wherein the voltage surges are caused by bouncing of one of the charging breakers (12).

## Patentansprüche

1. Umrichteranordnung, die Folgendes umfasst:
einen Leistungswandler (1);
Schutzschalter (7), die für den Anschluss an ein Wechselstromnetz (6) ausgelegt sind;
Umrichteranschlüsse (8) zum Anschluss des Leistungswandlers an das Wechselstromnetz (6) über die Leistungsschalter (7); und
eine Hilfsstromversorgungsanordnung (10), die Folgendes umfasst:
Schalter (13), die so angeordnet sind, dass sie die Stromversorgungsanordnung (10) mit den Umrichteranschlüssen (8) verbinden;
eine Hilfsstromversorgung (14) und Ladeschalter (12), wobei die Hilfsstromversorgung (14) über die Ladeschalter (12) mit den Umrichteranschlüssen (8) zwischen dem Leistungswandler (1) und den Leistungsschaltern (7) verbunden ist, wobei die Hilfsstromversorgung (14) zum Laden von Gate-Einheiten von Zellenschaltern (S) mindestens einer Umrichterzelle (3) des Leistungswandlers beim Anfahren des Leistungswandlers ausgebildet ist;
einen Transformator (11) zur Erhöhung der Spannung von der Hilfsstromversorgung (14) zum Leistungswandler (1), wobei der Transformator zwischen den Ladeschutzschaltern (12) und den Schaltern (13) der Hilfsstromversorgungsanordnung (10) angeschlossen ist; und
eine Kondensatoranordnung (4a, 4b), die mindestens einen Kondensator umfasst, der zwischen den Ladeschaltern (12) und den Umrichteranschlüssen (8) auf der Niederspannungsseite des Transformators (11) und/oder auf der Hochspannungsseite des Transformators (11) angeschlossen ist;
wobei die Kondensatoranordnung (4) so ausgelegt ist, dass sie die Halbleiter der Zellenschalter (S) vor Spannungsspitzen (dv/dt) während des Anlaufs des Leistungswandlers (1) schützt.

2. Umrichteranordnung nach Anspruch 1, wobei jeder der Ladeschalter (12) einen Halbleiterschalter umfasst.

3. Umrichteranordnung nach einem der vorhergehenden Ansprüche, wobei die Zellenschalter (S) jeweils einen Gate-kommutierten Thyristor umfassen, z. B. einen Integrated Gate Commutated Thyristor (IGCT); einen Reverse Conducting IGCT (RC-IGCT); oder einen Bi-mode Gate Commutated Thyristor (BGCT).

4. Umrichteranordnung nach einem der vorhergehenden Ansprüche, wobei der Leistungswandler (1) für eine Hochspannungsanwendung, z. B. eine Hochspannungs-Gleichstrom (HVDC)-Anwendung, ausgelegt ist.

5. Verfahren zum Schutz von Halbleitern in Zellenschaltern (S) eines Leistungswandlers (1) einer Umrichteranordnung nach einem der vorhergehenden Ansprüche, wobei das Verfahren Folgendes umfasst:
Versorgen, mittels der Hilfsstromversorgung (14), der Gate-Einheiten der Zellenschalter (S) der mindestens einen Umrichterzelle (3) während des Starts des Leistungswandlers (1);
wobei die Kondensatoranordnung (4) die Halbleiter vor Spannungsspitzen (dv/dt) während des Anlaufs des Umrichters (1) schützt.

6. Verfahren nach Anspruch 5, wobei die Spannungsspitzen durch das Auslösen eines der Ladeschalter (12) verursacht werden.

## Revendications

1. Agencement de convertisseur comprenant :
un convertisseur de puissance (1) ;
des disjoncteurs (7) configurés pour être connectés à un secteur CA (6) ;
des bornes de convertisseur (8) pour connecter le convertisseur de puissance au secteur CA (6) via les disjoncteurs (7) ; et
un agencement d'alimentation électrique (10) auxiliaire comprenant :
des commutateurs (13) agencés pour connecter l'agencement d'alimentation électrique (10) aux bornes de convertisseur (8) ;
une alimentation électrique auxiliaire (14) et des disjoncteurs de charge (12), l'alimentation électrique auxiliaire (14) étant connectée via les disjoncteurs de charge (12) aux bornes de convertisseur (8) entre le convertisseur de puissance (1) et les disjoncteurs (7), l'alimentation électrique auxiliaire (14) étant configurée pour charger des unités de gâchettes de commutateurs de cellules (S) d'au moins une cellule de convertisseur (3) du convertisseur de puissance pendant un démarrage du convertisseur de puissance ;
un transformateur (11) pour augmenter la tension de l'alimentation électrique auxiliaire (14) au convertisseur de puissance (1), le transformateur étant connecté entre les disjoncteurs de charge (12) et les commutateurs (13) de l'agencement d'alimentation électrique auxiliaire (10) ; et
un agencement de condensateurs (4a, 4b) comprenant au moins un condensateur, connecté entre les disjoncteurs de charge (12) et les bornes de convertisseur (8) sur le côté basse tension du transformateur (11) et/ou sur le côté haute tension du transformateur (11) ;
l'agencement de condensateurs (4) étant configuré pour protéger des semiconducteurs des commutateurs de cellules (S) contre des surtensions (dv/dt) pendant le démarrage du convertisseur de puissance (1) ;

2. Agencement de convertisseur selon la revendication 1, chacun des disjoncteurs de charge (12) comprenant un commutateur à semiconducteurs.

3. Agencement de convertisseur selon l'une quelconque des revendications précédentes, les commutateurs de cellules (S) comprenant chacun un thyristor commuté par la gâchette, par ex. un thyristor intégré commuté par la gâchette, IGCT ; un IGCT à conduction inverse, RC-IGCT ; ou un thyristor commuté par la gâchette Bi-mode, BGCT.

4. Agencement de convertisseur selon l'une quelconque des revendications précédentes, le convertisseur de puissance (1) étant configuré pour une application haute tension, par ex. une application en courant continu haute tension, HVDC.

5. Procédé de protection de semiconducteurs dans des commutateurs de cellules (S) d'un convertisseur de puissance (1) d'un agencement de convertisseur selon l'une quelconque des revendications précédentes, le procédé comprenant :
l'alimentation, au moyen de l'alimentation électrique auxiliaire (14), des unités de gâchettes des commutateurs de cellules (S) desdites au moins une cellule de convertisseur (3) pendant un démarrage du convertisseur de puissance (1) ;
l'agencement de condensateurs (4) protégeant les semiconducteurs contre des surtensions (dv/dt) pendant le démarrage du convertisseur (1).

6. Procédé selon la revendication 5, les surtensions étant causées par des rebonds d'un des disjoncteurs de charge (12).
